# EUROPÄISCHE PATENTSCHRIFT

(11) **EP 2 089 779 B1**
(45) Veröffentlichungstag und Bekanntmachung des Hinweises auf die Patenterteilung: **01.02.2012**
(21) Anmeldenummer: 07847580.3
(22) Anmeldetag: 30.11.2007
(51) Int. Cl.: G05B 19/042

(54) **VORRICHTUNG ZUR BESTIMMUNG UND/ODER ÜBERWACHUNG EINER PROZESSGRÖßE**
APPARATUS FOR DETERMINING AND/OR MONITORING A PROCESS VARIABLE
DISPOSITIF DE DÉTERMNATION ET/OU DE SURVEILLANCE D'UNE GRANDEUR DE TRAITEMENT

(30) Priorität: 12.12.2006 DE 102006058925
(43) Veröffentlichungstag der Anmeldung: 19.08.2009
(73) Patentinhaber: Endress+Hauser GmbH+Co. KG, 79689 Maulburg (DE)
(72) Erfinder: DIETERLE, Roland, 79539 Lörrach (DE); HUMPERT, Axel, 77866 Reinau (DE); WERNET, Armin, 79618 Rheinfelden (DE)
(74) Vertreter: Andres, Angelika Maria
(86) Internationale Anmeldenummer: PCT/EP2007/063064
(87) Internationale Veröffentlichungsnummer: WO 2008/071562

(56) Entgegenhaltungen:
- EP-A- 1 202 139

## Beschreibung

Die Erfindung betrifft eine Vorrichtung zur Bestimmung und/oder Überwachung mindestens einer Prozessgröße gemäß dem Oberbegriff des Patentanspruchs 1. Bei der Prozessgröße handelt es sich beispielsweise um den Füllstand, die Dichte, die Viskosität, den Druck, den pH-Wert oder um die elektrische Leitfähigkeit eines Mediums, bei welchem es sich beispielsweise um eine Flüssigkeit oder um ein Schüttgut handelt.

Messgeräte der Prozess- und Autornatisierungstechnik weisen meist zumindest eine Sondeneinheit, welche ausgehend von der Prozessgröße oder von einer Änderung der Prozessgröße eine Messgröße erzeugt, und eine Endstufe auf, wobei die Endstufe ein passendes Ausgangssignal in Abhängigkeit von der Messgröße bzw. von der Prozessgröße oder einer Änderung einer der beiden Größen erzeugt. Bei vielen stromgesteuerten Endstufen, welche z.B. ein 4...20 mA-Signal erzeugen, wird die Funktion einer Interlockdiode angeboten. Damit kann das Bedienpersonal /der Kunde direkt an einem Messgerät den Ist-Wert des Stromausganges mit einem gewöhnlichen Multimeter messen, d.h. direkt vor Ort lässt sich der Messwert abgreifen. Ein Nachteil der Anordnung ist, dass in dem Fall, dass die Interlockdiode nicht durch einen Multimeter-Messgerät überbrückt ist, d.h. dass keine Messung durchgeführt wird, die Interlockdiode in den 4...20 mA-Strompfad geschaltet ist. Es fällt also immer eine gewisse Spannung, z.B. 0,7 V über der Diode ab. Den nachgeschalteten Schaltungsteilen fehlt diese Spannung bei der Versorgung. Dies führt bei Geräten, die mit einer niedrigen Klemmenspannung betrieben werden, oft zu Problemen, da die Messgeräte ausschließlich mit der Restspannung funktionieren müssen (z.B. 9,3 V anstatt 10 V Klemmenspannung).
Die EP 1 202 139 A1 zeigt ein HART-Feldgerät, bei dem die Busspannung überwacht wird und bei Unterschreitung eines Minimums ausgewählte Komponenten des Feldgerätes ausgeschaltet werden.

Die Aufgabe der Erfindung besteht somit darin, ein Messgerät vorzuschlagen, dessen Funktionieren auch mit geringer zur Verfügung stehender Energie ermöglicht wird.

Die Erfindung löst die Aufgabe dadurch, dass mindestens eine Prüfbuchse vorgesehen ist, über welche das Stromsignal abgreifbar ist,
und dass mindestens ein Schalter vorgesehen ist, über welchen die Prüfbuchse zu- und/oder abschaltbar ist oder über welchen ein Spannungsabfall über die Prüfbuchse veränderbar ist.

Eine Ausgestaltung sieht vor, dass die Messeinheit die Spannung misst, welche am Energieeingang anliegt.

Eine Ausgestaltung beinhaltet, dass die Steuereinheit den gemessenen Spannungswert mit einer Sollspannung vergleicht.

Eine Ausgestaltung beinhaltet, dass das elektrische Stromsignal korrespondierend der Prozessgröße und/oder einer Änderung der Prozessgröße ausgestaltet ist.

Eine Ausgestaltung beinhaltet, dass mindestens eine Interlockdiode vorgesehen ist, welche elektrisch mit der Prüfbuchse verbunden ist.

Eine Ausgestaltung beinhaltet, dass über den Schaller ein Spannungsabfall über die Interlockdiode veränderbar ist.

Eine Ausgestaltung sieht vor, dass der Schalter und die Interlockdiode derartig ausgestaltet und aufeinander abgestimmt sind, dass der Schalter die Interlockdiode in mindestens einem Schalterzustand überbrückt.

Eine Ausgestaltung beinhaltet, dass die Steuereinheit und der Schalter derartig ausgestaltet und aufeinander abgestimmt sind, dass die Steuereinheit den Schalter betätigt. Die Steuereinheit öffnet bzw. schließt also den Schalter und wirkt damit auch auf die Interlockdiode ein.

In einer Ausgestaltung der Erfindung wird somit ein Kompromiss zwischen der Interlockdiodenfunktionalität und der Minimierung der Klemmenspannung eingegangen. Ist die Versorgungsspannung zu gering, so wird die Interlockdiode und damit die Möglichkeit des Signalabgriffs ausgeschaltet.

Ein Beispiel: Ein Messgerät hat einen Klemmenspannungsbereich zwischen 10 V und 30V vorgegeben. Durch die Interlockdiode im Strornpfad verbleibt für das restliche Messgerät nur 9 V bis 29 V. Wenn diese Spannungsverringerung auf 9V problematisch ist, weil damit die nachfolgende Schaltung zu wenig Spannung hat, oder weil die von der Interlockdiode verbrauchte Energie (1 V * 20 mA = 20 mW) eingespart werden soll, so wird erfindungsgemäß die Interlockdiode überbrückt.

Die Erfindung wird anhand der nachfolgenden Zeichnung näher erläutert. Es zeigt:

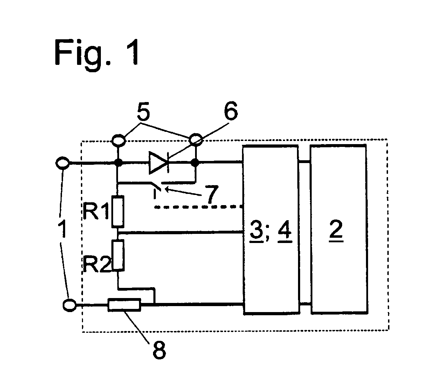

Fig. 1: eine schematische Darstellung eines Teiles eines erfindungsgemäßen Messgerätes.

In der Fig. 1 ist der für die Beschreibung der Erfindung wesentliche Teil eines Messgerätes dargestellt. So ist beispielsweise der Abschnitt der Sensorik nicht dargestellt. Die Signalerzeugungseinheit 4 erzeugt ausgehend von dem Messsignal für die Prozessgröße ein Ausgangssignal. Dabei handelt es sich beispielsweise um ein 4...20 mA-Signal. Dieses Signal wird über eine entsprechende Datenleitung beispielsweise an eine übergeordnete Leitwarte gegeben.

Vor Ort erlaubt es die Prüfbuchse 5, direkt das Signal abzugreifen. Dazu wird ein Strommessgerät/Multimeter an die zwei Kontakte der Prüfbuchse 5 geschaltet, die vor und hinter der Interlockdiode 6 angeordnet sind. Der niederohmige Widerstand des Multimeters verursacht selbst beim maximalen Strom eine Spannung, die in jedem Fall unter der Flussspannung der Interlockdiode 6 liegt. Damit fließt der Strom über das Multimeter und wird direkt erfasst.

Das Messgerät selbst wird über den Energieeingang 1 mit elektrischer Leistung z.B. über das Anlegen einer Spannung versorgt.

Erfindungsgemäß wird die anliegende Energie - bzw. in dieser Ausgestaltung die anliegende Spannung - von einer Messeinheit 2, hier in Verbindung mit den beiden elektrischen Widerständen R1 und R2 gemessen. Ausgehend von einem Vergleich des gemessenen Spannungswerts mit einem Sollwert steuert in diesem Beispiel die Steuereinheit 3 die Funktion der Prüfbuchse 5, indem sie über einen Schalter 7 die Interlockdiode 6 passend überbrückt oder nicht. Wird die Interlockdiode 6 überbrückt, so fällt dort auch keine Spannung ab. Gleichzeitig ist jedoch die Funktion der Prüfbuchse 5 nicht mehr gegeben.

Bei der Messeinheit 2, der Steuereinheit 3 und der Signalerzeugungseinheit 4 handelt es sich beispielsweise jeweils um einzelne Mikrocontroller. Die Funktionalitäten können entsprechend auch in einem gemeinsamen Mikrocontroller zusammengefasst werden.

### Bezugszeichenliste

**Tabelle 1**

| | |
|---|---|
| 1 | Energieeingang |
| 2 | Messeinheit |
| 3 | Steuereinheit |
| 4 | Signalerzeugungseinheit |
| 5 | Prüfbuchse |
| 6 | Interlockdiode |
| 7 | Schalter |
| 8 | Messwiderstand |

## Patentansprüche

1. Vorrichtung zur Bestimmung und/oder Überwachung mindestens einer Prozessgröße,
mit mindestens einem Energieeingang (1), über welchen die Vorrichtung Energie für den Betrieb der Vorrichtung empfängt,
mit mindestens einer Messeinheit (2), welche die am Energieeingang (1) anliegende Energie misst,
mit mindestens einer Steuereinheit (3), welche ausgehend von einem Vergleich der gemessenen Energie mit einem Sollwert den Energiebedarf mindestens einer Einheit der Vorrichtung steuert,
und mit mindestens einer Signalerzeugungseinheit (4), welche mindestens ein elektrisches Stromsignal erzeugt,
**dadurch gekennzeichnet,**
**dass** mindestens eine Prüfbuchse (5) vorgesehen ist, über welche das Stromsignal abgreifbar ist,
und **dass** mindestens ein Schalter (7) vorgesehen ist, über welchen die Prüfbuchse (5) zu- und/oder abschaltbar ist oder über welchen ein Spannungsabfall über die Prüfbuchse (5) veränderbar ist.

2. Vorrichtung nach Anspruch 1,
**dadurch gekennzeichnet,**
**dass** die Messeinheit (2) die elektrische Spannung misst, welche am Energieeingang (1) anliegt

3. Vorrichtung nach Anspruch 2,
dadurch gekenntzeichnet
dass die Steuereinheit (3) den gemessenen Spannungswert mit einer Sollspannung vergleicht.

4. Vorrichtung nach mindestens einem der Ansprüche 1 bis 3,
**dadurch gekennzeichnet,**
**dass** das elektrische Stromsignal korrespondierend der Prozessgröße und/oder einer Änderung der Prozessgröße ausgestaltet ist.

5. Vorrichtung nach mindestens einem der Ansprüche 1 bis 4,
dadurch gekenntzeichnet
dass mindestens eine Interlockdiode (6) vorgesehen ist, welche elektrisch mit der Prüfbuchse (5) verbunden ist.

6. Vorrichtung nach Anspruch 5,
**dadurch gekennzeichnet,**
**dass** über den Schalter (7) ein Spannungsabfall über die Interlockdiode (6) veränderbar ist.

7. Vorrichtung nach Anspruch 5 oder 6,
**dadurch gekennzeichnet,**
**dass** der Schalter (7) und die Interlockdiode (6) derartig ausgestaltet und aufeinander abgestimmt sind, dass der Schalter (7) die Interlockdiode (6) in mindestens einem Schalterzustand überbrückt.

8. Vorrichtung nach einem der vorangehenden Ansprüche ,
**dadurch gekennzeichnet,**
**dass** die Steuereinheit (3) und der Schalter (7) derartig ausgestaltet und aufeinander abgestimmt sind, dass die Steuereinheit (3) den Schalter (7) betätigt.

## Claims

1. Apparatus designed to determine and/or monitor at least one process variable,
with at least one energy input (1) via which the unit receives energy to operate the unit,
with at least one measuring unit (2) which measures the energy present at the energy input (1),
with at least one control unit (3) which controls the energy requirements of at least one unit of the apparatus based on a comparison of the measured energy with a target value, and with at least one signal generation unit (4) which generates at least one electrical current signal,
**characterized in that**
at least one test socket (5) is provided via which the current signal can be tapped,
and **in that** at least one switch (7) is provided via which the test socket can be enabled or disabled or via which a drop in voltage across the test socket (5) can be modified.

2. Apparatus as claimed in Claim 1,
**characterized in that**
the measuring unit (2) measures the electrical voltage which is present at the energy input (1).

3. Apparatus as claimed in Claim 2,
**characterized in that**
the control unit (3) compares the measured voltage value with a target voltage.

4. Apparatus as claimed in at least one of the Claims 1 to 3,
**characterized in that**
the electrical current signal is such that it corresponds to the process variable and/or a change in the process variable.

5. Apparatus as claimed in at least one of the Claims 1 to 4,
**characterized in that**
at least one interlock diode (6) is provided, said interlock diode being electrically connected to the test socket (5).

6. Apparatus as claimed in Claim 5,
**characterized in that**
a drop in voltage across the interlock diode (6) can be modified via the switch (7).

7. Apparatus as claimed in Claim 5 or 6,
**characterized in that**
the switch (7) and the interlock diode (6) are designed and harmonized with one another in such a way that the switch (7) bypasses the interlock diode (6) in at least one switch state.

8. Apparatus as claimed in one of the previous claims,
**characterized in that**
the control unit (3) and the switch (7) are designed and harmonized with one another in such a way that the control unit (3) actuates the switch (7).

## Revendications

1. Dispositif destiné à la détermination et/ou la surveillance d'au moins une grandeur process,
avec au moins une entrée énergie (1), par l'intermédiaire de laquelle le dispositif mesure, à l'aide d'au moins une unité de mesure (2), l'énergie présente sur l'entrée énergie (1),
avec au moins une unité de commande (3) qui, à partir de la comparaison de l'énergie mesurée avec une valeur de consigne, commande le besoin en énergie d'au moins une unité du dispositif,
et avec au moins une unité de génération de signal (4), qui génère au moins un signal de courant électrique,
**caractérisé en ce**
**qu'**est prévue au moins une douille d'essai (5), par l'intermédiaire de laquelle le signal de courant peut être prélevé,
et en ce qu'est prévu un interrupteur (7), par l'intermédiaire duquel la douille d'essai (5) est activable et/ou désactivable, ou par l'intermédiaire duquel une chute de tension à travers la douille d'essai (5) est modifiable.

2. Dispositif selon la revendication 1,
**caractérisé en ce**
**que** l'unité de mesure (2) mesure la tension électrique, qui est présente à l'entrée énergie (1).

3. Dispositif selon la revendication 2,
**caractérisé en ce**
**que** l'unité de commande (3) compare la valeur de tension mesurée avec une tension de consigne.

4. Dispositif selon l'une des revendications 1 à 3,
**caractérisé en ce**
**que** le signal de courant électrique est conçu de façon à correspondre à la grandeur process et/ou à une modification de la grandeur process.

5. Dispositif selon l'une des revendications 1 à 4,
**caractérisé en ce**
**qu'**est prévue au moins une diode d'interverrouillage (6), laquelle est reliée électriquement avec la douille d'essai (5).

6. Dispositif selon la revendication 5,
**caractérisé en ce**
**qu'**une chute de tension à travers la diode d'interverrouillage (6) est modifiable à l'aide de l'interrupteur (7).

7. Dispositif selon la revendication 5 ou 6,
**caractérisé en ce**
**que** l'interrupteur (7) et la diode d'interverrouillage (6) sont conçus et assortis l'un à l'autre de telle manière que l'interrupteur (7) court-circuite la diode d'interverrouillage (6) dans au moins un état de l'interrupteur.

8. Dispositif selon l'une des revendications précédentes,
**caractérisé en ce**
**que** l'unité de commande (3) et l'interrupteur (7) sont conçus et assortis l'un à l'autre de telle manière que l'unité de commande (3) actionne l'interrupteur (7).
